# EUROPEAN PATENT SPECIFICATION

(11) **EP 1 972 702 B1**
(45) Date of publication and mention of the grant of the patent: **25.09.2013**
(21) Application number: 07706498.8
(22) Date of filing: 10.01.2007
(51) Int. Cl.: C30B 29/38, H01L 21/338, H01L 29/812

(54) **METHOD FOR MANUFACTURING ALUMINUM NITRIDE CRYSTAL, ALUMINUM NITRIDE CRYSTAL, ALUMINUM NITRIDE CRYSTAL SUBSTRATE AND SEMICONDUCTOR DEVICE**
VERFAHREN ZUR HERSTELLUNG VON ALUMINIUMNITRIDKRISTALL, ALUMINIUMNITRIDKRISTALL, ALUMINIUMNITRIDKRISTALLSUBSTRAT UND HALBLEITERBAUELEMENT
PROCEDE DE FABRICATION DE CRISTAL DE NITRURE D'ALUMINIUM, CRISTAL DE NITRURE D'ALUMINIUM, SUBSTRAT DE CRISTAL DE NITRURE D'ALUMINIUM ET DISPOSITIF SEMI-CONDUCTEUR

(30) Priority: 12.01.2006 JP 2006005062
(43) Date of publication of application: 24.09.2008
(73) Proprietor: Sumitomo Electric Industries, Ltd., Osaka-shi, Osaka 541-0041 (JP)
(72) Inventor: MIZUHARA, Naho, Itami-shi, Hyogo 6640016 (JP); MIYANAGA, Michimasa, Itami-shi, Hyogo 6640016 (JP); KAWASE, Tomohiro, Itami-shi, Hyogo 6640016 (JP); FUJIWARA, Shinsuke, Itami-shi, Hyogo 6640016 (JP)
(74) Representative: Grünecker, Kinkeldey, Stockmair & Schwanhäusser
(86) International application number: PCT/JP2007/050151
(87) International publication number: WO 2007/080881

(56) References cited:
- FR-A1- 2 852 974
- JP-A- 2003 335 600
- JP-A- 2005 343 722
- JP-A- 2005 343 722
- MOKHOV E N ET AL: "Sublimation growth of AlN bulk crystals in Ta crucibles" JOURNAL OF CRYSTAL GROWTH, ELSEVIER, AMSTERDAM, NL LNKD- DOI:10.1016/J.JCRYSGRO.2005.03.016, vol. 281, no. 1, 15 July 2005 (2005-07-15) , pages 93-100, XP004953470 ISSN: 0022-0248
- DALMAU R ET AL: "AlN bulk crystals grown on SiC seeds" JOURNAL OF CRYSTAL GROWTH, ELSEVIER, AMSTERDAM, NL LNKD- DOI:10.1016/J.JCRYSGRO.2005.03.012, vol. 281, no. 1, 15 July 2005 (2005-07-15) , pages 68-74, XP004953466 ISSN: 0022-0248
- DALMAU R. ET AL.: 'AlN bulk crystals grown on SiC seeds' JOURNAL OF CRYSTAL GROWTH vol. 281, no. 1, 15 July 2005, pages 68 - 74, XP004953466
- EDGAR J.H. ET AL.: 'Bulk AlN crystal growth: self-seeding and seeding on 6H-SiC substrates' JOURNAL OF CRYSTAL GROWTH vol. 246, no. 3-4, December 2002, pages 187 - 193, XP004392373
- RAGHOTHAMACHAR B. ET AL.: 'X-ray characterization of bulk AlN single crystals grown by the sublimation technique' JOURNAL OF CRYSTAL GROWTH vol. 250, no. 1-2, March 2003, pages 244 - 250, XP004412889
- TANAKA M. ET AL.: 'Morphology and X-Ray Diffraction Peak Widths of Aluminum Nitride Single Crystals Prepared by the Sublimation Method' JAPANESE JOURNAL OF APPLIED PHYSICS no. 8B, PART 2, 15 August 1997, pages 1062 - 1064, XP003016004

## Description

### Technical Field

The present invention relates to methods of manufacturing aluminum nitride (AlN) crystals, and to AlN crystals and AlN-crystal substrates and semiconductor devices, and in particular relates to a method of manufacturing AlN crystal, and to AlN crystals, AlN crystal substrates, and semiconductor devices fabricated employing the AlN crystal substrates, that enable semiconductor devices having advantageous properties to be obtained.

### Background Art

AlN crystal substrates have gained attention as substrates for optoelectronic and other semiconductor devices on account of the crystal's having an energy bandgap of 6.2 eV, a thermal conductivity of approximately 3.3 WK⁻¹ cm⁻¹, and high electrical resistance.

AlN crystal substrates can be produced from AlN crystal grown by sublimation, hydride vapor-phase epitaxy (HVPE), or other deposition techniques onto the surface of seed-crystal substrates such as silicon (Si) or silicon-carbide (SiC) crystal substrates.
Non-Patent Reference 1: B. Raghothamachar, M. Dudley, J.C. Rojo, K Morgan and L.J. Schowalter, "X-ray Characterization of Bulk AIN Single Crystals Grown by the Sublimation Technique", Journal of Crystal Growth, Vol. 250, March 2003, p.244.
Non-Patent Reference 2: X. Hu et al., "AlGaN/GaN Heterostructure Field-Effect Transistors on Single-Crystal Bulk AlN", Applied Physics Letters, Vol. 82, No. 8, 2003, pp. 1299-1301.

In order to reduce semiconductor device manufacturing costs, vapor depositing nitride semiconductor monocrystalline layers onto an AlN crystal substrate having as large a surface as possible to obtain as many semiconductor devices as possible from a single AlN crystal substrate is effective.

The properties of semiconductor devices manufactured employing such AlN crystal substrates, however, are sometimes adversely affected, wherein development of an AlN crystal substrate for obtaining semiconductor devices having satisfactory properties has been desired.
US 2004/0187766 relates to a method of fabricating monocrystalline crystals and discloses all of the features in the preamble of claim 1.

### Disclosure of Invention

### Problems Inveention is to Solve

Therein, an object of the present invention is to make available AlN crystal manufacturing methods, and AlN crystals, AlN crystal substrates, and semiconductor devices fabricated employing the AlN crystal substrates, that make it possible to obtain semiconductor devices having advantageous device properties.

### Means for Resolving the Problems

The problems are solved by a method of manufacturing aluminum nitride crystal as set forth in claim1, an aluminum nitride crystal as set forth in claim 3, an aluminum nitride crystal substrate as set forth in claim 6, and a semiconductor device as set forth in claim 7. Preferred embodiments are disclosed in the dependent claims.

### Effects of the Invention

The present invention affords methods of manufacturing AlN crystals, and AlN crystals, AlN crystal substrates, and semiconductor devices fabricated employing the AlN crystal substrates, that enable semiconductor devices having advantageous properties to be obtained.

### Brief Description of Drawings

Fig. 1 is a cross-sectional schematic diagram graphically explaining a part of the manufacturing process in one example of an AlN crystal manufacturing method of the present invention.
Fig. 2 is a cross-sectional schematic diagram graphically explaining another part of the manufacturing process in the one example of an AlN crystal manufacturing method of the present invention.
Fig. 3 is a cross-sectional schematic diagram of an AlN crystal growth device employed in examples of embodying the present invention.
Fig. 4 is a cross-sectional schematic diagram graphically explaining one example of method of obtaining AlN crystal substrates from an AlN crystal, in an example of embodying the present invention.
Fig. 5 is a cross-sectional schematic diagram graphically explaining one example of a method of growing AlN crystal onto the surface of an AlN crystal substrate, in an example of embodying the present invention.
Fig. 6 is a cross-sectional schematic diagram graphically explaining another example of a method of obtaining an AlN crystal substrate from AlN crystal, in an example of embodying the present invention.
Fig. 7 is a cross-sectional schematic diagram representing the structure of a field-effect transistor fabricated in an embodiment of the present invention.

### Legend

1: crucible
2: AlN source
3: SiC seed-crystal substrate
4: seed-crystal substrate protector
5: reaction chamber
6: high-frequency heating coil
7: heating element
8, 8b, 10: AlN crystal
8a: range
9, 11, 22: AlN crystal substrates
12: AlN film
13: GaN film
14: AlGaN film
15, 17: Ti films
16: Al film
18: Au film
19: source electrode
20: drain electrode
21: gate electrode

### Best Mode for Carrying Out the Invention

Below, a description of modes of embodying the present invention will be made. It should be understood that in the drawings for the present invention, identical reference marks indicate identical or corresponding parts.

In order to improve semiconductor device properties, the conventional thinking has been that the lower the dislocation density is in the AlN crystal constituting AlN crystal substrates, the better; the present inventors, however, discovered that if the dislocation density in the AlN crystal constituting AlN crystal substrates is too low, the semiconductor device properties deteriorate. The present inventors then found that in AlN crystal substrates constituted from bulk AlN crystal having a front side whose surface area is 10 cm² or more, by having the dislocation density in the AlN crystal constituting the AlN crystal substrate be from 1 × 10³ dislocations/cm² to 1 × 10⁶ dislocations/cm², the properties of the semiconductor devices prove to be ideal, wherein they came to complete the present invention.

More specifically, in instances in which semiconductor devices have been fabricated, by processes including the successive deposition of semiconductor films, onto AlN crystal substrates constituted by AlN crystal having a front side whose surface area is 10 cm² or more and whose dislocation density is less than 1 × 10³ dislocations/cm², the semiconductor device properties degenerate. Likewise, in instances in which semiconductor devices have been fabricated, by processes including the successive deposition of semiconductor films, onto AlN crystal substrates constituted by AlN crystal having a front side whose surface area is 10 cm² or more and whose dislocation density is higher than 1 × 10⁶ dislocations/cm², the semiconductor device properties degenerate.

Yet the present inventors also discovered that in instances in which semiconductor devices have been fabricated, by processes including the successive deposition of semiconductor films, onto AlN crystal substrates constituted by AlN crystal having a front side whose surface area is 10 cm² or more and whose dislocation density is from 2 × 10⁴ dislocations/cm² to 5 × 10⁶ dislocations/cm², the semiconductor device properties turn out to be quite satisfactory.

The reasons semiconductor device properties deteriorate in implementations where the dislocation density in the AlN crystal constituting an AlN crystal substrate is, at less than 1 × 10³ dislocations/cm², too low are not clear, but are presumed to be as follows. Namely, because dislocations in an AlN crystal substrate function as getters for impurities within the AlN crystal substrate and for deposits originating in off-stoichiometries in the AlN crystal substrate, if the dislocation density in the AlN crystal constituting the AlN crystal substrate is too low, the dislocations' function as getters will not be sufficiently manifest. Presumably, as a consequence the impurities and deposits remain in the regions of the AlN-crystal-substrate-constituting AlN crystal where there are few dislocations, degrading the crystalline quality of the regions where the dislocations are few, and in turn degrading the crystalline quality of semiconductor films grown over the regions where dislocations are few. Semiconductor device properties are thought to be thereby adversely affected in implementations in which the dislocation density in the AlN-crystal-substrate-constituting AlN crystal is, at less than 1 × 10³ dislocations/cm², too low.

Moreover, in the AlN crystal constituting the AlN crystal substrate, at least one dislocation type selected from the group consisting of screw dislocations, edge dislocations, and mixed dislocations in which the screw and edge dislocations are mixed can be included. Herein, the ratio of the dislocation density of screw dislocations to the density of dislocations overall in the AlN crystal (that is, the density of the AlN crystal dislocations just noted) is preferably 0.2 or less. In implementations in which semiconductor devices have been fabricated, by processes including the successive deposition of semiconductor films, onto AlN crystal substrates constituted by AlN crystal in which the ratio of the dislocation density of screw dislocations to the density of dislocations overall is 0.2 or less, the semiconductor device properties tend to be quite satisfactory.

Additionally, the present inventors discovered that in implementations in which semiconductor devices have been fabricated, by processes including the successive deposition of semiconductor films, onto the front side of AlN crystal substrates constituted by AlN crystal in which the dislocation density of screw dislocations is 1 × 10⁴ dislocations/cm² or less, the semiconductor device properties tend to be even more satisfactory, and that there is a similar tendency also in implementations in which screw dislocations are not present in the AlN crystal constituting the AlN crystal substrate.

Herein, in the present invention, dislocation density in the AlN crystal is determined by a method in which the AlN crystal surface is etched for 30 minutes employing molten KOH-NaOH mixture (KOH mass : NaOH mass = 1 : 1) at a temperature of 250°C, and the density of etch pits forming on the surface is measured.

Moreover, in the present invention, to which of the edge, screw, and edge/screw mixed dislocations a dislocation in the AlN crystal corresponds is decided from the size of the etch pits formed on the AlN crystal substrate surface by the above method. In an etch pit corresponding to a screw dislocation, the largest diametric span of the pit is from 10 µm to 15 µm, and in an etch pit corresponding to an edge dislocation, the largest diametric span of the pit is from 1 µm to 5 µm. Herein, "largest diametric span" in the present invention means the length of the longest line segment among line segments connecting two points present on the margin of an etch pit.

With AlN crystal of the present invention, in the course of growing AlN crystal by, for example, sublimation onto a seed-crystal substrate such as an Si crystal substrate or an SiC crystal substrate, and the AlN crystal being lengthened by the AlN crystal growth, with the major portion of the dislocations in the AlN crystal presumably propagating in directions other than along the *c* axis, the dislocation density in the AlN crystal lessens at a greater remove from the seed-crystal substrate, and this fact is utilized in the AlN crystal's manufacture.

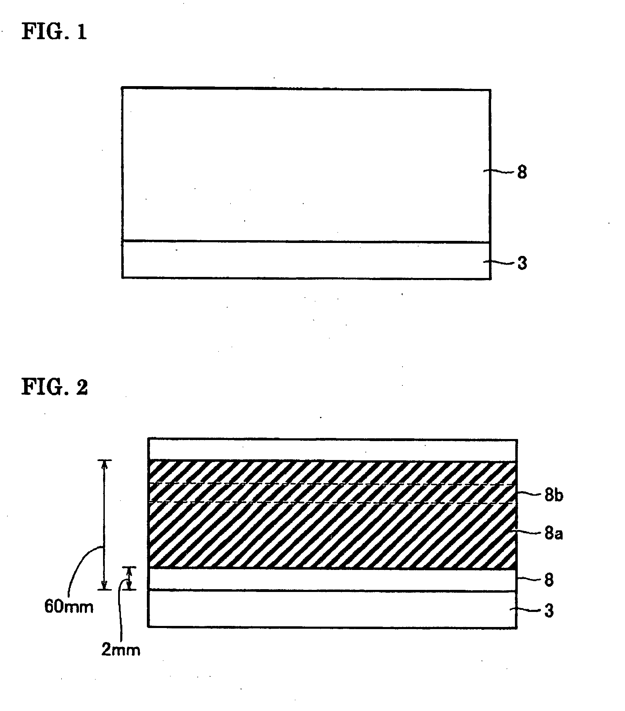

For example, as illustrated in the cross-sectional schematic diagram in Fig. 1, first, a SiC seed-crystal substrate 3 having the surface whose area is 10 cm² of more is prepared as seed-crystal substrate, and an AlN crystal 8 is grown by sublimation onto the surface of the SiC seed-crystal substrate 3.

Next, as illustrated in the cross-sectional schematic diagram in Fig. 2, an AlN crystal 8*b* of at least a piece of the AlN crystal 8, lying in a range 8*a* (the shaded area in Fig. 2) into the AlN crystal 8 of from 2 mm to 60 mm inclusive-preferably of from 3 mm to 20 mm inclusive-from the surface of the SiC seed-crystal substrate 3 (that is, a piece obtained by cutting the AlN crystal 8 at the short dashed line in Fig. 2) is picked out.

The AlN crystal 8*b* manufactured in this manner was rendered the AlN crystal having the surface whose area is 10 cm² or more with a dislocation density in the AlN crystal being between 1 × 10³ dislocations/cm² and 1 × 10⁶ dislocations/cm² inclusive-preferably with a dislocation density in the AlN crystal being between 2 × 10⁴ dislocations/cm² and 5 × 10⁶ dislocations/cm² inclusive.

Alternately, utilizing as a seed-crystal substrate an AlN crystal substrate composed of the AlN crystal 8*b* manufactured in the above manner, an AlN crystal is grown by sublimation onto the surface of the AlN crystal substrate serving as seed-crystal substrate, and then at least a piece of the grown AlN crystal is picked out, also in which manner the AlN crystal having the surface whose area is 10 cm² or more with a dislocation density in the AlN crystal being between 1 × 10³ dislocations/cm² and 1 × 10⁶ dislocations/cm² inclusive-preferably with a dislocation density in the AlN crystal being between 2 × 10⁴ dislocations/cm² and 5 × 10⁵ dislocations/cm² inclusive can be manufactured.

Furthermore, the SiC seed-crystal substrate 3 serving as seed-crystal substrate in the forgoing preferably has a thickness of 150 µm or more to 400 µm or less, and more preferably has a thickness of 150 µm or more to 350 µm or less, with a thickness of 150 µm or more to 300 µm or less being most preferable. Bringing thickness of the SiC seed-crystal substrate 3 to above thicknesses facilitates manufacturing the AlN crystal having the dislocation densities described above.

Moreover, in the foregoing, a temperature of the SiC seed-crystal substrate 3 during the growth of the aluminum nitride crystal 8 onto the surface of the SiC seed-crystal substrate 3 is preferably 1650°C or more. It is conceivable that screw dislocations are reduced utilizing the fact that employing the SiC seed-crystal substrate 3 differing approximately 1 % in lattice constant from the AlN crystal 8 causes lattice relaxation to occur at a few µm from the SiC seed-crystal substrate 3, resulting in that a large part of the screw dislocations loops and disappears. Additionally, growing the AlN crystal 8 under the conditions such that the AlN crystal 8 is subjected to step-flow growth in the early stage of its growth so as not to produce tensile stress caused by the combination of holes and crystal grains leads to dislocation density reduction. And, such dislocation behavior remarkably appears with a temperature of the SiC seed-crystal substrate 3 during the growth of the aluminum nitride crystal 8 onto the surface of the SiC seed-crystal substrate 3 being 1650°C or more.

### Embodiment

### AlN crystal substrate fabrication

An AlN crystal is grown by sublimation onto the surface of a SiC seed-crystal substrate 2 inches in diameter and 250 µm in thickness in the following manner.

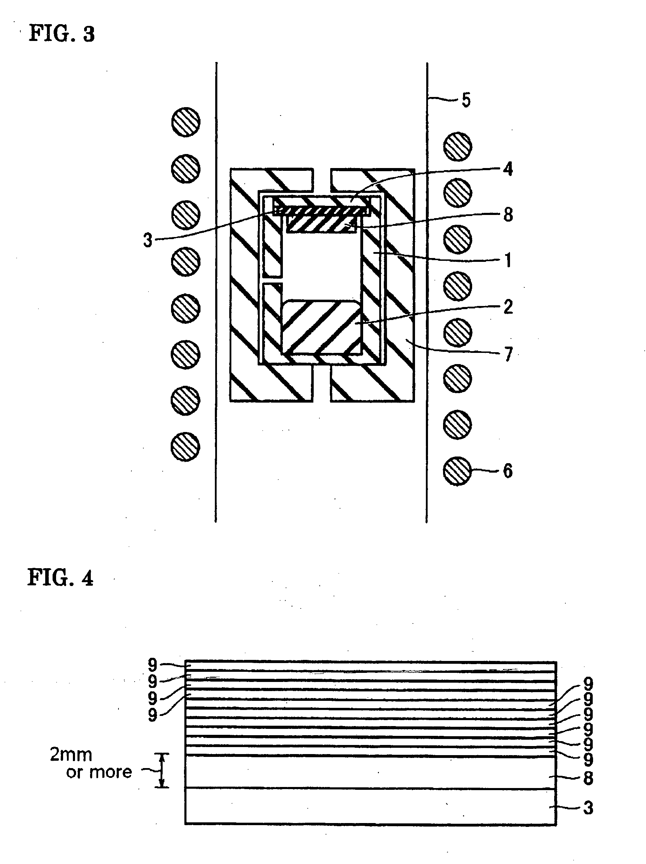

A cross-sectional schematic diagram of an AlN crystal growing device employed in this embodiment is illustrated in Fig. 3. First, an AlN source 2 such as AlN powder is accommodated in the under part of a graphite crucible 1, and the SiC seed-crystal substrate 3 whose surface has been processed to be flat is arranged in the top part of the crucible 1. Herein, for the purpose of preventing SiC from sublimating from the back side of the SiC seed-crystal substrate 3, a seed-crystal substrate protector 4 made of graphite is arranged so as to closely attach to the back side.

Next, while a nitrogen gas is being fed into a reaction chamber 5, a heating element 7 is heated with a high-frequency heating coil 6 to raise temperature in the crucible 1. Herein, with temperature in the part of the crucible 1 where the SiC seed-crystal substrate 3 is arranged being kept at 2000°C, and with temperature in the part of the crucible 1 where the AlN source 2 is accommodated being kept at 2200°C, AlN is sublimated from the AlN source 2 to grow an AlN crystal film about 30 µm in thickness onto the surface of the SiC seed-crystal substrate 3 arranged in the top part of the crucible 1, and then the temperature in where the AlN source 2 is accommodated is raised to 2400°C, and the AlN crystal 8 is grown for 100 hours.

After the growth, the AlN crystal 8 is cooled to room temperature (of 25°C), and is removed from the device. Then the 10 mm-thick AlN crystal 8 is grown onto the SiC seed-crystal substrate 3 with diameter of 2 inches.

Subsequently, as illustrated in the cross-sectional schematic diagram in Fig. 4, slicing is started at an interval 2 mm or more into the AlN crystal 8 obtained in above manner from the surface of the SiC seed-crystal substrate 3, and 10 AlN crystal substrates 9 having the (0002) plane as the surface, with diameter of 2 inches are fabricated. Successively, the Al faces of these 10 AlN crystal substrates 9 are specular-polished.

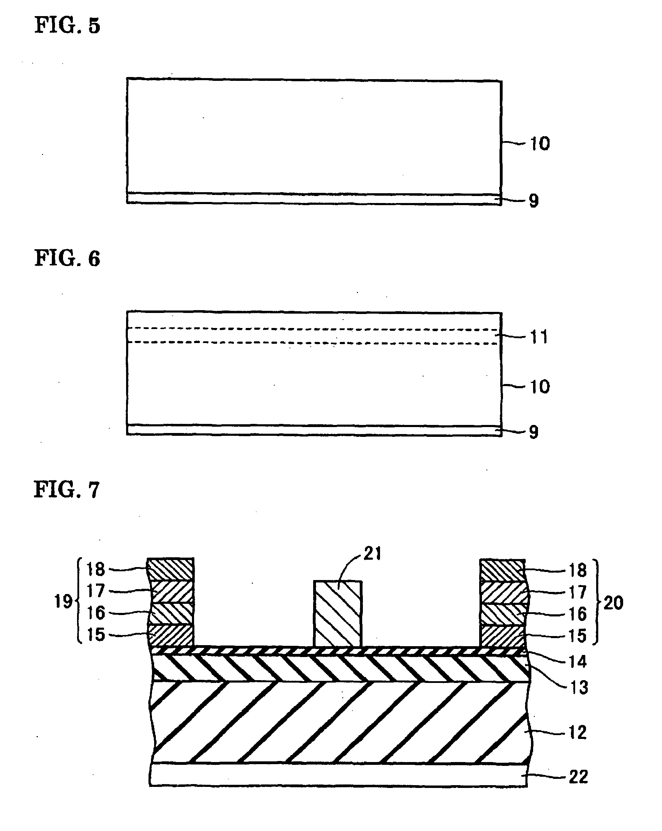

Furthermore, as illustrated in the cross-sectional schematic diagram in Fig. 5, an AlN crystal 10 is grown onto the surfaces of the AlN crystal substrates 9 obtained in above manner by sublimation in which the growing device illustrated in Fig. 1 is employed.

Herein, with the temperature in where the AlN crystal substrates 9 are arranged being kept at 2000°C, the temperature in where the AlN source 2 is accommodated is raised from room temperature to 2400°C at a constant gradient, and AlN is sublimated from the AlN source 2, to grow the AlN crystal 10 for 100 hours.

After the growth, the grown AlN crystal 10 is cooled to room temperature (of 25°C), and is removed from the growing device. As a result, the AlN crystal 10 having a diameter of a little less than 2 inches is produced. Subsequently, as illustrated in the cross-sectional schematic diagram in Fig. 6, the AlN crystal 10 is sliced to pick out an AlN crystal substrate 11.

### Dislocation density measurement

The surfaces of 10 AlN crystal substrates 9 picked out from above AlN crystal 8 and of any one AlN crystal substrate 11 picked out from above AlN crystal 10 are each etched for 30 minutes with a molten KOH-NaOH mixture (KOH mass : NaOH mass =1: 1) to form etch pits corresponding to dislocations. Density of the etch pits is calculated to obtain a dislocation density and distribution in each of the AlN crystal substrates. Then the dislocations do not concentrate within the AlN crystal substrate surfaces, but exist uniformly on the entire surfaces.

Herein, dislocation density in the AlN crystal substrates 9 has a tendency to lower with greater distances from the SiC seed-crystal substrate 3.

Furthermore, dislocations in the AlN crystal substrate 11 picked out from the AlN crystal 10 have the almost same density and distribution as the AlN crystal substrates 9 utilized as seed-crystal substrate. For this reason, the AlN crystal substrate 11 with a desired dislocation density and distribution can be produced with adequate reproducibility.

### Semiconductor device fabrication

Semiconductor films and metal films are successively deposited onto the Al face of each of 10 AlN crystal substrates 22 sliced off from the AlN crystal 8 or AlN crystal 10 and differing from each other in dislocation density to fabricate field-effect transistors having the structure illustrated in the cross-sectional schematic diagram in Fig. 7.

Specifically, first, a 0.5 µm-thick AlN film 12, 100 nm-thick GaN film 13, and 30 nm-thick AlGaN film 14 are epitaxially grown to deposit them successively on the Al face of the AlN crystal substrates 22 by metalorganic chemical vapor deposition (MOCVD). In depositing these films, the AlN film 12 and GaN film 13 are each undoped.

Next, a Ti film 15, Al film 16, Ti film 17 and Au film 18 are deposited successively onto the surface of the AlGaN film 14 to form a source electrode 19 and drain electrode 20 separately.

Subsequently, a gate electrode 21 composed of an Au film is formed between the source electrode 19 and the drain electrode 20 on the surface of the AlGaN film 14. In forming the gate electrode 21, the gate length is 2 µm, and intervals between the gate electrode 21 and the source electrode 19, and between the gate electrode 21 and the drain electrode 20 are respectively 10 µm.

And, the wafer after the formation of the gate electrode 21 is divided into chips, and the field-effect transistors having the structure illustrated in Fig. 7 are fabricated.

### Semiconductor device evaluation

As a result of measuring breakdown voltages of the field-effect transistors fabricated in above manner between the gate electrode 21 and the drain electrode 20, breakdown voltages of those of the field-effect transistors which are fabricated employing an AlN crystal substrate composed of an AlN crystal having a dislocation density of 1 × 10³ dislocations/cm² or more to 1 × 10⁶ dislocations/cm² or less are high, and particularly in those of the field-effect transistors which are fabricated employing an AlN crystal substrate composed of an AlN crystal having a dislocation density of 2 × 10⁴ dislocations/cm² or more to 1 × 10⁶ dislocations/cm² or less, their breakdown voltages stabilize at a higher 1200 to 1250 V

Breakdown voltages of those of the field-effect transistors which are fabricated employing an AlN crystal substrate composed of an AlN crystal having dislocation density of 1 × 10² dislocations/cm², and of those of the field-effect transistors which are fabricated employing an AlN crystal substrate composed of an AlN crystal having dislocation density of 5 × 10⁶ dislocations/cm², between the gate electrode 21 and the drain electrode 20, however, are approximately a low one-half (500 to 600 V) of the breakdown voltages of the field-effect transistors fabricated employing the AlN crystal substrate composed of the AlN crystal in which a dislocation density is between 2 × 10⁴ dislocations/cm² and 1 × 10⁵ dislocations/cm² inclusive.

Furthermore, even if the AlN crystal substrate composed of the AlN crystal in which a dislocation density is between 2 × 10⁴ dislocations/cm² and 1 × 10⁵ dislocations/cm² inclusive is employed, with at least one type of dislocation selected from the group consisting of screw, edge, and mixed dislocations being included in the AlN crystal, and with a ratio of the dislocation density in terms of screw dislocations to the density of all dislocations in the AlN crystal being more than 0.2, field-effect transistor breakdown voltages between the gate electrode 21 and the drain electrode 20 are brought to 1050 to 1100 V, meaning that the break down voltages are made lower compared with the breakdown voltages (1200 to 1250 V) in the situation in which above ratio of the dislocation density in terms of screw dislocations is 0.2 or less,.

Moreover, if an AlN crystal substrate composed of an AlN crystal having a dislocation density of 2 × 10⁴ dislocations/cm² or more to 1 × 10⁵ dislocations/cm² or less, and including at least one type of dislocation selected from the group consisting of the screw, edge, and mixed dislocations, with a ratio of the dislocation density in terms of screw dislocations to the density of all dislocations in the AlN crystal being 0.2 or less, and additionally with the dislocation density in terms of screw dislocations being 1 × 10⁴ dislocations/cm² or less is employed, above field-effect transistor breakdown voltages further rise, and stabilize at around 1300 V Accordingly, dislocation density in terms of screw dislocations in AlN crystal substrates is preferably 1 × 10⁴ dislocations/cm² or less.

Herein, although in this embodiment, the semiconductor device evaluation is carried out based on the field-effect transistor breakdown voltages between the gate electrode and the drain electrode, it is believed that as to other semiconductor devices whose properties are influenced by crystallinity of semiconductor films, evaluation results similar to those in above examples can be obtained.

The presently disclosed embodiments and implementation examples should in all respects be considered to be illustrative and not limiting. The scope of the present invention is set forth not by the foregoing description but by the scope of the patent claims, and is intended to include meanings equivalent to the scope of the patent claims and all modifications within the scope.

### Industrial Applicability

With the AlN crystal substrates of the present invention, the following semiconductor devices can be fabricated: light-emitting devices (such as light-emitting, and laser diodes); electronic devices (such as rectifiers, bipolar transistors, field-effect transistors, and HEMTs); semiconductor sensors (such as temperature, pressure, and radiation sensors, and visible light-ultraviolet detector); surface acoustic wave (SAW) devices; acceleration sensors; micro electro mechanical system (MEMS) parts; piezoelectric vibrators; resonators; and piezoelectric actuators, for example.

## Claims

1. A method of manufacturing aluminum nitride crystal, including:
a step of growing aluminum nitride crystal onto the surface of an SiC seed-crystal substrate; and
a step of picking out at least a portion of the aluminum nitride crystal lying in a range of from 2 mm to 60 mm from the SiC seed-crystal substrate surface into the aluminum nitride crystal,
wherein
the thickness of the SiC seed-crystal substrate (3) is between 150 µm and 300 µm inclusive, and
the temperature of the SiC seed-crystal substrate when the aluminum nitride crystal is grown onto the SiC seed-crystal substrate surface is 1650° C or more; and
the aluminum nitride crystal growth onto the SiC seed-crystal substrate surface is carried out by sublimation.

2. The aluminum nitride crystal manufacturing method as set forth in claim 1, further comprising:
a step of growing aluminum nitride crystal onto the surface of the picked-out aluminum nitride crystal.

3. An aluminum nitride crystal having a front side whose surface area is 10 cm² or more, with dislocation density in the aluminum nitride crystal being between 1x10³ dislocations/cm² and 1x10⁶ dislocations/cm² inclusive, and including at least one dislocation type selected from the group consisting of screw dislocations, edge dislocations, and mixed dislocations, wherein the ratio of the dislocation density of screw dislocations to said dislocation density is 0.2 or less.

4. The aluminum nitride crystal set forth in claim 3, **characterized in that** the dislocation density is between 2x10⁴ dislocations/cm² and 5x10⁵ dislocations/cm² inclusive.

5. The aluminum nitride crystal set forth in claim 3, **characterized in that** the dislocation density of screw dislocations is 1x10⁴ dislocations/cm² or less.

6. An aluminum nitride crystal substrate constituted by the aluminum nitride crystal set forth in any of claim 3 through claim 5.

7. A semiconductor device fabricated employing the aluminum nitride crystal substrate set forth in claim 6.

## Patentansprüche

1. Verfahren zur Herstellung eines Aluminiumnitridkristalls, das Folgendes einschließt:
einen Schritt des Wachsens eines Aluminiumnitridkristalls auf eine Oberfläche eines SiC Saatkristallsubstrats; und
ein Schritt des Herausnehmens mindestens eines Teils des Aluminiumnitridkristalls, der in einem Bereich von 2mm bis 60mm von der SiC Saatkristallsubstratoberfläche zum Aluminiumnitridkristall liegt,
wobei die Dicke des SiC Saatkristallsubstrats (3) zwischen 150 µm und einschließlich 300 µm ist, und
die Temperatur des SiC Saatkristallsubstrats, wenn der Aluminiumnitridkristall auf der SiC Saatkristallsubstratoberfläche aufgewachsen wird, 1650° C oder mehr ist; und
das Aluminiumnitridkristallwachstum auf der SiC Saatkristallsubstratoberfläche durch Sublimation ausgeführt wird.

2. Aluminiumnitridkristallherstellungsverfahren nach Anspruch 1, das weiterhin umfasst:
einen Schritt des Wachsens des Aluminiumnitridkristalls auf die Oberfläche des herausgenommenen Aluminiumnitridkristalls.

3. Aluminiumnitridkristall mit einer Vorderseite, dessen Oberflächenfläche 10 cm² oder mehr ist bei einer Versetzungsdichte im Aluminiumnitridkristall zwischen 1 x 10³ Versetzungen/cm² und einschließlich 1 x 10⁶ Versetzungen/cm², und der mindestens einen Versetzungstyp einschließt, der aus der Gruppe ausgewählt wird, die aus Schraubenversetzungen, Randversetzungen und gemischte Versetzungen besteht, wobei das Verhältnis der Versetzungsdichte von Schraubenversetzungen zur Versetzungsdichte 0,2 oder weniger ist.

4. Aluminiumnitridkristall nach Anspruch 3, **dadurch gekennzeichnet, dass** die Versetzungsdichte zwischen 2 x 10⁴ Versetzungen/cm² und einschließlich 5 x 10⁵ Versetzungen/cm² ist.

5. Aluminiumnitridkristall, nach Anspruch 3, **dadurch gekennzeichnet, dass** die Versetzungsdichte von Schraubenversetzungen 1 x 10⁴ Versetzungen/cm² oder weniger ist.

6. Aluminiumnitridkristallsubstrat, das aus dem Aluminiumnitridkristall gemäß einem der Ansprüche 3 bis 5 gebildet wird.

7. Halbleitervorrichtung, das unter Verwendung des Aluminiumnitridkristallsubstrats gemäß Anspruch 6 verwendet wird.

## Revendications

1. Procédé de fabrication d'un cristal de nitrure d'aluminium, incluant :
une étape où on fait croître le cristal de nitrure d'aluminium sur la surface d'un substrat de cristal formant germe de SiC, et
une étape de prélèvement d'au moins une partie du cristal de nitrure d'aluminium demeurant dans une plage allant de 2 mm à 60 mm à partir de la surface du substrat de cristal formant germe de SiC dans le cristal de nitrure d'aluminium,
dans lequel
l'épaisseur du substrat de cristal formant germe de SiC (3) se trouve entre 150 µm et 300 µm inclus, et
la température du substrat de cristal formant germe de SiC lorsqu'on fait croître le cristal de nitrure d'aluminium sur la surface du substrat de cristal formant germe de SiC est de 1650 °C ou plus, et
la croissance du cristal de nitrure d'aluminium sur la surface du substrat de cristal formant germe de SiC est réalisée par sublimation.

2. Procédé de fabrication d'un cristal de nitrure d'aluminium selon la revendication 1, comprenant en outre :
une étape consistant à faire croître un cristal de nitrure d'aluminium sur la surface du cristal de nitrure d'aluminium prélevé.

3. Cristal de nitrure d'aluminium possédant un côté avant dont la surface est de 10 cm² ou plus, présentant une densité de dislocations dans le cristal de nitrure d'aluminium située entre 1 x 10³ dislocations / cm² et 1 x 10⁶ dislocations / cm² inclus, et comprenant au moins un type de dislocation sélectionné à partir du groupe constitué de dislocations vis, de dislocations coins et de dislocations mixtes, dans lequel le rapport de la densité de dislocations des dislocations vis sur ladite densité de dislocations est de 0,2 ou moins.

4. Cristal de nitrure d'aluminium selon la revendication 3, **caractérisé en ce que** la densité de dislocations se trouve entre 2 x 10⁴ dislocations / cm² et 5 x 10⁵ dislocations / cm² inclus.

5. Cristal de nitrure d'aluminium selon la revendication 3, **caractérisé en ce que** la densité de dislocations des dislocations vis est de 1 x 10⁴ dislocations / cm² ou moins.

6. Substrat de cristal de nitrure d'aluminium constitué par le cristal de nitrure d'aluminium conforme à l'une quelconque des revendications 3 à 5.

7. Composant à semiconducteur fabriqué en utilisant le substrat de cristal de nitrure d'aluminium conforme à la revendication 6.
